(19) Europäisches Patentamt
European Patent Office
Office européen des brevets

(11) Veröffentlichungsnummer: **0 476 332 A2**

(12) **EUROPÄISCHE PATENTANMELDUNG**

(21) Anmeldenummer: **91113955.8**

(51) Int. Cl.5: **C08J 7/12**, C08J 7/14

(22) Anmeldetag: **21.08.91**

(30) Priorität: **06.09.90 DE 4028210**

(43) Veröffentlichungstag der Anmeldung:
**25.03.92 Patentblatt 92/13**

(84) Benannte Vertragsstaaten:
**BE DE FR GB NL**

(71) Anmelder: **BASF Aktiengesellschaft**
**Carl-Bosch-Strasse 38**
**W-6700 Ludwigshafen(DE)**

(72) Erfinder: **Rosenau, Bernhard, Dr.**
**Karolinenterrasse 12**
**W-6730 Neustadt(DE)**
Erfinder: **Hisgen, Bernd, Dr.**
**Rheinstrasse 8**
**W-6708 Neuhofen(DE)**
Erfinder: **Heinz, Gerhard, Dr.**
**Im Vogelsang 2**
**W-6719 Weisenheim(DE)**
Erfinder: **McKee, Graham Edmund, Dr.**
**Kastanienweg 8**
**W-6940 Weinheim(DE)**
Erfinder: **Muenstedt, Helmut, Dr.**
**An der Altenbach 41**
**W-6706 Wachenheim(DE)**
Erfinder: **Eberle, Wolfgang, Dr.**
**Am Hemel 20**
**W-6500 Mainz 1(DE)**
Erfinder: **Zeiner, Hartmut, Dr.**
**Paracelsustrasse 18**
**W-6700 Ludwigshafen(DE)**

(54) **Verfahren zur Oberflächenbehandlung von Formkörpern auf der Basis von flüssigkristallinen Polymeren.**

(57) Verfahren zur Oberflächenbehandlung von Formkörpern auf der Basis von flüssigkristallinen Polymeren mit sauren oder alkalischen Reagentien, wobei die sauren oder alkalischen Reagentien in einem Lösungsmittel eingesetzt werden, das zu mindestens 60 Gew.-% aus einem organischen Lösungsmittel besteht.

EP 0 476 332 A2

Die vorliegende Erfindung betrifft ein Verfahren zur Oberflächenbehandlung von Formkörpern auf der Basis von flüssigkristallinen Polymeren mit sauren oder alkalischen Reagentien.

Flüssigkristalline Polymere stellen eine Gruppe von thermoplastisch verarbeitbaren Polymeren mit hoher Temperaturbeständigkeit und niedrigem thermischen Ausdehnungskoeffizienten dar. Darüber hinaus werden durch die optisch anisotrope Schmelzphase bei der Herstellung von Formkörpern durch Spritzguß oder Extrusion in Fließrichtung Orientierungen hervorgerufen, die interessante Anwendungsmöglichkeiten eröffnen.

Schwierigkeiten bereitet jedoch die Lackierung oder Metallisierung von Formkörpern auf der Basis von flüssigkristallinen Polymeren, da die erzielten Haftfestigkeiten nicht zufriedenstellen. Aus der EP-A-312 268 ist ein Verfahren bekannt, nach dem zur Verbesserung der Haftfestigkeit bei der Metallisierung von Formkörpern auf der Basis von flüssigkristallinen Polymeren eine Behandlung mit einer mindestens 80 gew.-%igen wäßrigen Lösung von Schwefelsäure durchgeführt wird. Die Formmasse aus der der Formkörper hergestellt wird, enthält 5 bis 80 Gew.-% eines bestimmten anorganischen Füllstoffs.

Aus der EP-A-305 846 sind thermoplastische Formmassen zur Herstellung von gedruckten Leiterplatten bekannt, die neben einem flüssigkristallinen Polymeren noch einen faserförmigen anorganischen Füllstoff sowie ein Erdalkalimetallcarbonat zwingend enthalten. Vor der Metallisierung werden die aus den beschriebenen Formmassen hergestellten Formkörper in an sich bekannter Weise mit wäßrigen alkalischen und sauren Reagentien vorbehandelt.

Nach den vorstehend beschriebenen Verfahren wird bereits eine Verbesserung der Haftfestigkeit von Metall- oder Lackschichten auf den Formkörper erzielt, doch wäre eine weitere Verbesserung erstrebenswert.

Aufgabe der vorliegenden Erfindung war es daher, ein Verfahren zur Oberflächenbehandlung von Formkörpern auf der Basis von flüssigkristallinen Polymeren zur Verfügung zu stellen, welches einfach durchführbar ist und die Haftung von auf den Formkörper aufgebrachten Metall- oder Lackschichten verbessert.

Erfindungsgemäß wird diese Aufgabe durch ein Verfahren zur Oberflächenbehandlung von Formkörpern auf der Basis von flüssigkristallinen Polymeren, mit alkalischen oder sauren Reagentien gelöst, wobei die sauren oder alkalischen Reagentien in einem Lösungsmittel eingesetzt werden, das zu mindestens 60 Gew.-% aus einem organischen Lösungsmittel besteht. Das erfindungsgemäße Verfahren liefert gegenüber den an sich bekannten Behandlungsverfahren, bei denen die Vorbehandlung mit wäßrigen Säuren oder Alkalien durchgeführt wird, verbesserte Haftungen insbesondere bei der anschließenden Metallisierung.

Im erfindungsgemäßen Verfahren werden Formkörper auf der Basis von flüssigkristallinen Polymeren eingesetzt, d.h. die zugrundeliegenden Formmassen enthalten als Hauptbestandteil mindestens ein flüssigkristallines Polymer sowie ggf. Füllstoffe, Kautschuke und andere übliche Zusätze.

Als flüssigkristalline Polymere werden thermotrop mesomorphe Polymere eingesetzt.

Diese weisen eine anisotrope Schmelzphase auf, die leicht nach dem in der DE-A 25 20 819 beschriebenen Verfahren mit dem Polarisationsmikroskop nachgewiesen werden kann. Zwischen gekreuzten Polarisatoren weisen die Polymerschmelzen, die in einer Schichtdicke von 10 $\mu$m zwischen Glasplatten aufgetragen sind, Texturen auf, die einer mesomorphen Phase zugeordnet werden können.

Zur Erzielung einer anisotropen (flüssig-kristallinen) Schmelzphase ist in der Regel ein bestimmtes Maß an Linearität in der Hauptkette erforderlich, welche durch entsprechende Wahl der Mengenverhältnisse der Monomeren erzielt werden kann. Die Anisotropie der Schmelzphase und die damit einhergehende Orientierung der Polymermoleküle führen zu sehr hohen Festigkeiten und Steifigkeiten in aus derartigen Polymeren hergestellten Formkörpern.

Allgemein läßt sich sagen, daß thermotrop mesomorphe Polymere im allgemeinen Einheiten enthalten, die sich ableiten von

$a_1$) aromatischen oder aliphatischen Dicarbonsäuren,

$a_2$) aromatischen oder aliphatischen Diolen, Diaminen oder entsprechenden Monomeren mit einer Amino- und einer Hydroxylgruppe,

$a_3$) aromatischen Hydroxy- und Aminocarbonsäuren und

$a_4$) aromatischen Thiocarbonsäuren bzw. Dithiolen oder Thiophenolen.

Aus diesen Monomeren lassen sich durch entsprechende Kombination z.B. Polyester, Polyesteramide, Polyesterimide, Polyestercarbonate, Polyetherester, Polyetheresteramide, Polyesteramidimide, Polyestercarbamide und Polyetheresterimide herstellen.

Die Zusammensetzung dieser Produkte kann in weiten Bereichen schwanken und es sind eine Vielzahl von Monomeren einsetzbar. Wesentlich ist, daß die Polymere thermotrop mesomorphe Eigenschaften aufweisen, was leicht nach dem bereits erwähnten, in der DE-A 25 20 819 beschriebenen Verfahren zu überprüfen ist.

Nicht alle Kombinationen von Monomeren $a_1$) bis $a_4$) in beliebigen molaren Verhältnissen führen zu thermotrop mesomorphen Polymeren, eine allgemeine Angabe von geeigneten Mengenverhältnissen ist kaum möglich.

In der einschlägigen Literatur und in einer Vielzahl von Patentanmeldungen sind jedoch geeignete thermotrop mesomorphe Systeme beschrieben, die nun nachstehend zunächst über eine beispielhafte Aufzählung geeigneter Monomerer und entsprechender Polymerer näher erläutert werden sollen.

Monomere $a_1$):

Terephthalsäure, Isophthalsäure, 2,6-Naphthalindicarbonsäure, 2,7-Naphthalindicarbonsäure, 4,4'-Dicarboxydiphenyl, 4,4"-Dicarboxyterphenyl, Dicarboxydiphenylderivate der allgemeinen Formeln I und II

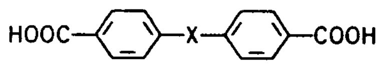

(I)

| | |
|---|---|
| X = O | 4,4'-Dicarboxydiphenylether |
| X = $CH_2CH_2$ | 1,2-Di-(4-carboxyphenyl)ethan |
| X = $OCH_2CH_2O$ | 1,2-Di-(4-carboxyphenoxy)-ethan |
| X = $O(CH_2)_4O$ | 1,4-Di-(4-carboxyphenoxy)-butan |

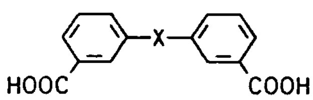

(II)

| | |
|---|---|
| X = O | 3,3'-Dicarboxydiphenylether |
| X = $CH_2CH_2$ | 1,2-Di-(3-carboxyphenyl)ethan |
| X = $OCH_2CH_2O$ | 1,2-Di-(3-carboxyphenoxy)-ethan |
| X = $O(CH_2)_4O$ | 1,4-Di-(3-carboxyphenoxy)-butan |

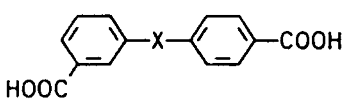

| | |
|---|---|
| X = O | 3,4'-Dicarboxydiphenylether |
| X = $CH_2CH_2$ | 1,2-(3,4'-Dicarboxy)-diphenyl-ethan |
| X = $OCH_2CH_2O$ | 1,2-(4-Dicarboxy)-diphenoxy-ethan |
| X = $O(CH_2)_4O$ | 1,4-(3,4'-Dicarboxy)-diphen-oxybutan |

Weiter sind zu nennen Dicarbonsäuren der allgemeinen Formel III und IV

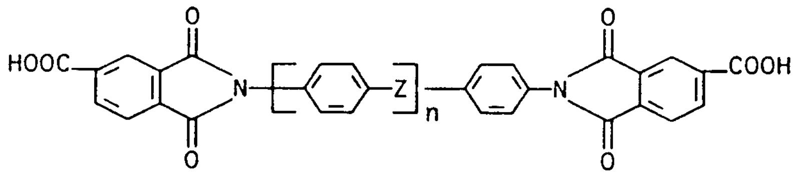

(III)

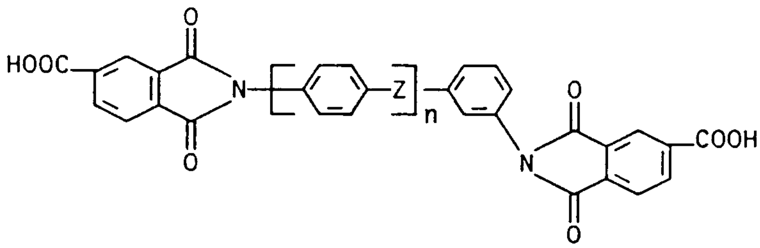

(IV)

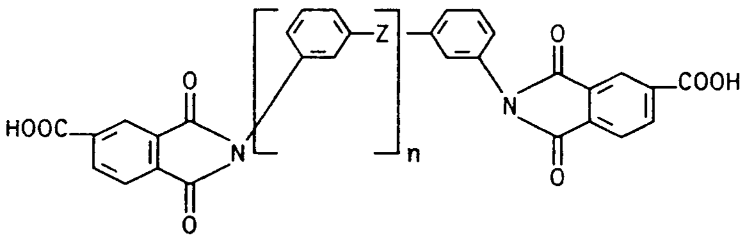

(V)

wobei Z jeweils -O-, -S-, $-SO_2-$, $-CH_2-$, $-C(CH_3)_2$ oder eine chemische Bindung und n 0 oder 1 ist.

Beispiele hierfür sind

Z = 0 4,4'-, 3,4'- bzw. 3,3'-Di-(4-carboxy-N-phthalimido)diphenylether
Z = $CH_2$ 4,4'-, 3,4'- bzw. 3,3'-Di-(4-carboxy-N-phthalimido)diphenylmethan
Z = $SO_2$ 4,4'-, 3,4'- bzw. 3,3'-Di-(4-carboxy-N-phthalimido)diphenylsulfon
Z = CO 4,4'-, 3,4'- bzw. 3,3'-Di-(4-carboxy-N-phthalimido)diphenylketon
Z = S 4,4'-, 3,4'- bzw. 3,3'-Di-(4-carboxy-N-phthalimido)diphenylsulfidund z.B.
Z = $C(CH_3)_2$ 2,2-Di-[4,4'-di(4-carboxy-N-phthalimido)phenyl]propan.

Ebenfalls geeignet sind p,p-, m,m- und p,m-Dicarboxyphenylcarbonate der allgemeinen Formeln VI bis VIII

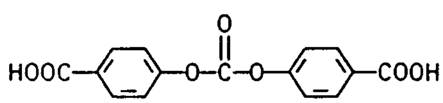

(VI)

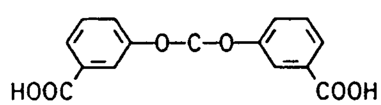

(VII)

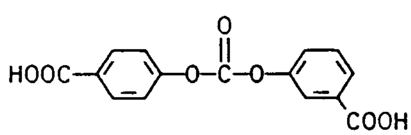

(VIII).

Die vorstehend genannten Carbonsäuren können auch Substituenten wie $C_1$-$C_4$-Alkyl-, $C_1$-$C_4$-Alkoxygruppen oder Halogenatome aufweisen. Schließlich seien auch noch einige aliphatische Dicarbonsäuren wie cis- und trans-1,4-Cyclohexandicarbonsäure und 1,3-Cyclohexandicarbonsäure sowie deren entsprechend substituierte Derivate erwähnt.

Monomere $a_2$:

Hydrochinon, Methylhydrochinon, Phenylhydrochinon, tert.-Butylhydrochinon, Chlorhydrochinon, 4,4'-Dihydroxydiphenyl, 1,4-Di-(4-hydroxyphenyl)benzol, 1,2-Di-(4-hydroxyphenoxy)ethan, 4,4'-Dihydroxydiphenylether, 4,4'-Dihydroxydiphenylsulfon, 3,3'-Dihydroxydiphenyl, 3,3'-Dihydroxydiphenylether, 3,4'-Dihydroxydiphenyl, 3,4'-Dihydroxydiphenylether, 2,2-Di-(4-hydroxyphenyl)propan, 1,6-, 2,6- und 2,7-Dihydroxynaphthalin, 3,3',5,5'-Tetramethyl-4,4'-dihydroxydiphenyl, 4,4'-(Di(p-hydroxyphenoxy)-diphenylsulfon, Harnstoff, 1,4-Diaminobenzol, 1,3-Diaminobenzol, 3-Aminophenol, 4-Aminophenol, trans- und cis-1,4-Cyclohexandiol, trans-1,3-Cyclohexandiol und cis-1,2-Cyclohexandiol. Es versteht sich, daß auch hier wieder allgemein Substituenten wie bei den Monomeren $a_1$) vorhanden sein können.

Monomere $a_3$:

4-Hydroxybenzoesäure, 3-Hydroxybenzoesäure, 6-Hydroxynaphthalin-2-carbonsäure, 6-Hydroxynaphthalin-1-carbonsäure, 3-Aminobenzoesäure, 4-Aminobenzoesäure und deren $C_1$-$C_4$-Alkyl-, $C_1$-$C_4$-Alkoxy- oder Halogenderivate wie 3-Methyl-4-hydroxybenzoesäure, 3,5-Dimethyl-4-hydroxybenzoesäure, 2,6-Dimethyl-4-hydroxybenzoesäure, 3-Methoxy-4-hydroxybenzoesäure und 2, 5-Dichlor-4-hydroxybenzoesäure um nur einige Beispiele zu nennen.

Monomere $a_4$:

4-Mercaptobenzoesäure, 3-Mercaptobenzoesäure, 6-Mercaptonaphthalin-2-carbonsäure, 2,7-Dithionaphthalin, 2,6-Dithionaphthalin, 1,4-Dithiobenzol und 1,3-Dithiobenzol sowie deren $C_1$-$C_4$-Alkyl-, $C_1$-$C_4$-Alkoxy- und Halogen-derivate.

Weitere geeignete Monomere aus den Gruppen $a_1$) bis $a_4$) sind z.B. in der EP-A 206 600 aufgeführt.

Für das erfindungsgemäße Verfahren bevorzugt werden flüssigkristalline Polymere wie sie in den EP-A-226 839, DE-A-35 42 814, DE-A-35 42 813, DE-A-35 42 777, DE-A-35 42 778, DE-A-35 42 779, DE-A-35 42 855, DE-A-35 42 856, DE-A-35 42 957, DE-A-35 42 796, DE-A-35 42 797, DE-A-35 42 798, DE-A-35 42 831, DE-A-35 42 832, DE-A-35 42 833, DE-A-36 21 519, DE-A-36 22 137, DE-A-36 29 211, DE-A-36 29 210, DE-A-36 29 209, DE-A-36 29 208 und der DE-A-37 00 821 beschrieben werden, wobei insbesondere die in der DE-A-36 29 211 beschriebenen flüssigkristallinen Polyester sich als vorteilhaft erwiesen haben. Es sei jedoch nochmals betont, daß sich prinzipiell alle thermotrop mesomorphen Polymeren eignen.

In manchen Fällen hat es sich als vorteilhaft erwiesen, wenn dem flüssigkristallinen Polymeren ein Kautschuk zugesetzt wird. Geeignete Kautschuke sind solche, wie sie dem Fachmann an sich zur Schlagzähmodifizierung thermoplastischer Polymerer bekannt sind, wobei natürlich darauf zu achten ist, daß der Kautschuk bei den hohen Verarbeitungstemperaturen der flüssigkristallinen Polymeren stabil ist. Nur stellvertretend seien hier Pfropfkautschuke auf der Basis von Polybutadien und/oder Acrylsäureestern mit darauf aufgepfropften Hüllen aus Styrol oder Styrolderivaten, Acrylnitril, Methacrylnitril und/oder (Meth)-acrylsäureestern genannt. Entsprechende Produkte sind dem Fachmann bekannt und kommerziell erhältlich, so daß sich hier nähere Angaben erübrigen.

Weiterhin ist es für bestimmte Anwendungszwecke vorteilhaft, dem flüssigkristallinen Polymeren einen oder mehrere anorganische Füllstoffe zuzusetzen.

Hier sind insbesondere die in der EP-A-305 846 genannten anorganischen faserförmigen Materialien geeignet. Hier sind Glasfasern, Kaliumtitanatfasern, Wollastonit, keramische $Al_2O_3/SiO_2$-Fasern, Borfasern, Siliciumcarbidfasern und Alkalimetallmetaphosphatfasern zu nennen, von denen Glasfasern, Kaliumtitanatfasern und Wollastonit besonders bevorzugt werden.

Diese werden besonders bevorzugt zusammen mit einem Erdalkalimetallcarbonat eingesetzt, wobei vorzugsweise die Carbonate des Magnesiums, Calciums, Strontiums und Bariums zu nennen sind, insbesondere das Eutektikum von Calcium- und Magnesiumcarbonat, der sog. Dolomit.

Als Füllstoffe sind weiterhin die in der EP-A-312 268 beschriebenen Oxide, Sulfate, Phosphate und Silikate der Metalle der 2. Hauptgruppe des Periodensystems sowie die Oxide des Si, Zn, Pb, Sb und Bi anzuführen.

Der Anteil der vorstehend genannten Füllstoffe und Kautschuke liegen im allgemeinen im Bereich von 5 bis 80 Gew.-%, vorzugsweise von 10 bis 50 Gew.-%. Falls Mischungen aus faserförmigen Füllstoffen und Erdalkalimetallcarbonaten eingesetzt werden, beträgt deren Anteil vorzugsweise 3 bis 50, insbesondere 10 bis 40 bzw. 3 bis 30, insbesondere 5 bis 20 Gew.-%, bezogen auf das Gesamtgewicht der Formmasse. Die Herstellung der Formmassen kann auf an sich bekannte Art durch Abmischen der Komponenten auf einem Extruder oder in einer anderen geeigneten Mischvorrichtung, wie einem Henschel-Mixer oder einem Banbury-Mischer erfolgen. Entsprechende Verfahren sind dem Fachmann bekannt.

Die Herstellung der nach dem erfindungsgemäßen Verfahren zu behandelnden Formkörper aus den Formmassen erfolgt vorzugsweise durch Spritzguß, obwohl auch die anderen bekannten Verfahren zur Herstellung von Formkörpern aus thermoplastischen Formmassen geeignet sind.

Die erfindungsgemäße Vorbehandlung mit sauren oder alkalischen Reagentien wird derart durchgeführt,

daß die Formkörper mit einer Lösung dieser Reagentien behandelt werden, die zu mindestens 60, vorzugsweise mindestens 80 und insbesondere ausschließlich aus einem organischen Lösungsmittel besteht. Als saure Reagentien sind insbesondere Sauerstoffsäuren der Elemente der V. bis VII. Hauptgruppe des Periodensystems zu nennen. Beispiele hierfür sind die Sauerstoffsäuren des Schwefels, Phosphors und Stickstoffs, z.B. $H_2SO_4$, $HNO_3$, $H_3PO_4$ sowie Chromschwefelsäure, um nur einige zu nennen. Weiterhin eignen sich die Halogenwasserstoffsäuren HCl, HBr, HJ und HF, wobei HCl besonders zu nennen ist. Als alkalische Reagnetien sind vorzugsweise Alkali- und Erdalkalimetallhydroxide aufzuführen, insbesondere NaOH, KOH, $Ba(OH)_2$ und $Ca(OH)_2$ oder deren Mischungen. Es ist auch möglich und manchmal vorteilhaft, eine Behandlung mit einem sauren und einem alkalischen Behandlungsmittel durchzuführen.

Die Vorbehandlungsmittel werden im erfindungsgemäßen Verfahren in einem überwiegend organischen Lösungsmittel eingesetzt, welches max. 40 Gew.-% Wasser enthalten kann. Als geeignete organische Lösungsmittel sind insbesondere niedere Alkohole, Ketone und Carbonsäureester oder dipolare aprotische Lösungsmittel wie N-Methylpyrolidon zu nennen. Besonders bevorzugt werden wegen ihres niedrigen Preises und der guten Verfügbarkeit Alkohole mit 1 bis 4 C-Atomen, insbesondere Methanol, Ethanol, i- und n-Propanol sowie die isomeren Butanole.

Es können auch Mischungen verschiedener organischer Lösungsmittel verwendet werden.

Die Temperatur, bei der die Vorbehandlung durchgeführt wird, liegt im allgemeinen zwischen 10 ° C und dem Siedepunkt des Lösungsmittels, in dem die sauren oder alkalischen Reagentien gelöst sind; bevorzugt ist die Behandlung bei Raumtemperatur, da hierfür keine Thermostatisiervorrichtungen erforderlich sind.

Die Konzentration der Reagentien im Lösungsmittel unterliegt an sich keiner besonderen Beschränkung; je höher konzentriert die Lösung, desto kürzer kann in der Regel die Behandlungszeit gewählt werden oder es ist eine Absenkung der Behandlungstemperatur möglich.

Die Behandlungsdauer liegt in der Regel zwischen 10 Sekunden und 60 Minuten, vorzugsweise im Bereich von 1 bis 40 Minuten.

Nach dem erfindungsgemäßen Verfahren werden Formkörper mit einer Oberfläche erhalten, die sich gut metallisieren oder lackieren lassen. Zur Metallisierung bzw. Lackierung können die üblichen, dem Fachmann bekannten Verfahren angewandt werden.

Die erste Metallschicht kann dabei physikalisch oder naßchemisch aufgebracht und anschließlich stromlos oder in einem galvanischen Schritt auf die gewünschte Dicke verstärkt werden.

Beispiele für physikalische Verfahren sind die Physical Vapour Deposition (PVD) oder das Sputtern in Niederdruckplasma.

übliche naßchemische Verfahren beinhalten in der Regel eine Konditionierung, einen Aufschluß, ggf. einen Neutralisationsschritt, eine Aktivierung, Bekeimung und anschließend eine stromlose Metallisierung.

Beispiele

A: Herstellung des flüssigkristallinen Polymeren

In einen Rührautoklaven mit 70 1 Nenninhalt wurden 28 Mol Terephthalsäure, 12 Mol Isophthalsäure, 60 Mol p-Hydroxybenzoesäure, 20 Mol Hydrochinon, 20 Mol 4,4'-Dihydroxybiphenyl sowie 189 Mol Essigsäureanhydrid eingefüllt und durch Heizen und Rühren die Reaktion in Gang gebracht. Die Solltemperatur des ölheizmantels wurde zunächst auf 150 ° C und dann im Verlauf von 3 h gleichmäßig auf 360 ° C ansteigend eingestellt. Dabei destillierten Essigsäure und der überschuß Essigsäureanhydrid ab; am Ende dieser Phase war eine Innentemperatur von 340 ° C erreicht. Zur Vervollständigung der Polykondensation wurde der Innendruck innerhalb 30 bis 40' auf ca. 400 mbar reduziert, wobei ein deutlicher Anstieg der Schmelzviskosität eintrat. Das entstandene Polymere wurde durch eine Düsenplatte ausgepreßt und nach Durchlaufen eines Wasserbades granuliert. Seine inhärente Viskosität war 2,54 dl/g, gemessen bei 60 ° C in 0,1 %iger (Gew./Vol.) Pentafluorphenollösung, differentialthermoanalytische und polarisationsmikroskopische Untersuchung des Polymeren zeigte bei 320 ° C übergang in eine flüssigkristalline Schmelze an.

Das so erhaltene flüssigkristalline Polymere (LCP) wurde auf einem Zweischneckenextruder (ZSK 30 der Fa. Werner & Pfleiderer) aufgeschmolzen, ggf. die Füll- und Verstärkungsstoffe bzw. Kautschuke oder weitere Polymere zugegeben und bei 330 bis 360 ° C extrudiert und granuliert. Tabelle 1 gibt die Zusammensetzung der Formmassen an.

Die Formmassen, die die Komponente K1 oder K2 enthielten, wurden bei Temperaturen von 300 bis 330 ° C hergestellt, wobei der Kautschuk (K1 bzw. K2) als wäßrige Dispersion zugegeben und das freiwerdende Wasser entlang des Extruders abgezogen wurde.

Tabelle 1

| Formmasse | LCP | Glasfasern | Komponente (Gew.-%) PES/K1/K2[1)] | Dolomit |
|---|---|---|---|---|
| 1 | 100 | - | - | - |
| 2 | 70 | 30 | - | - |
| 3 | 70 | 20 | - | 10 |
| 4 | 45 | - | 55 PES | - |
| 5 | 45 | - | 35 PES | 20 |
| 6 | 45 | 20 | 25 PES | 10 |
| 7 | 56 | 24 | 20 K1 | - |
| 8 | 56 | 24 | 20 K2 | - |
| 9 | 42 | 18 | 40 PES | |
| 10 | 38,5 | 16,5 | 35 PES + 10K1 | |
| 11 | 35 | 15 | 30 PES + 10K2 | 10 |

1) PES = Polyethersulfon der Formel

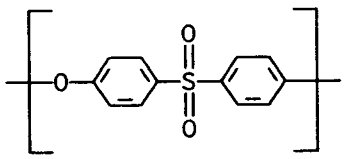

mit einer intrinsischen Viskosität von 0,58, gemessen in einer Lösung (1 g/100 ml) in Phenol/o-Dichlorbenzol (1:1) bei 25°C.

K1 = Pfropfkautschuk mit einer Pfropfgrundlage (70 Gew.-%) aus n-Butylacrylat/Dihydrodicyclopentadienylacrylat (Gew.-Verh. 98:2) und einer Pfropfhülle aus Styrol und Acrylnitril im Gew.-Verh. 3:1, hergestellt gemäß DE-A-24 44 584.

K2 = Pfropfkautschuk mit einer Pfropfgrundlage (80 Gew.-%) aus Polybutadien und einer Pfropfhülle aus Styrol und Acrylnitril im Gew.-Verh. 3:1, hergestellt gemäß EP-A-22 216.

Aus den erhaltenen Granulaten wurde im Spritzguß bei Massetemperaturen von 330 °C und Formtemperaturen von 80 °C Platten der Dimension 60 x 80 x 2 mm gespritzt und anschließend in Anlehnung an das in der EP-A 305 846 beschriebene Verfahren mit einer Kupferschicht metallisiert, nachdem sie den in der nachfolgenden Tabelle 2 beschriebenen Vorbehandlungen unterworfen worden waren.

Im einzelnen wurden folgende Vorbehandlungen durchgeführt

- B1 keine Vorbehandlung
- B2 10 Gew.-% HCl, wäßrige Lösung, 30 min, Raumtemperatur
- B3 10 Gew.-% KOH, wäßrige Lösung, 30 min, Raumtemperatur
- B4 10 Gew.-% KOH in $CH_3OH$, 30 min, Raumtemperatur
- B5 10 Gew.-% KOH in i-$C_3H_7OH$, 30 min, Raumtemperatur

B6 10 Gew.-% HCl in $CH_3OH$, 30 min, Raumtemperatur
B7 10 Gew.-% KOH in $CH_3OH$, 15 min, Raumtemperatur
+ 2 Gew.-% HCl in $CH_3OH$, 5 min, Raumtemperatur

Zur Metallisierung wurden die Substrate nach der Vorbehandlung zunächst durch besputtern im Vakuum mit einer 1 bis 3 µm dicken Cu-Schicht versehen, die anschließend galvanisch bei Stromdicken von 20 bis 30 mA/cm$^2$ auf eine Dicke von 40±4 µm verstärkt wurde.

Zur Prüfung der Abzugsfestigkeiten wurden aus diesen Platten 25 mm breite Streifen herausgesägt und die Haftfestigkeit der Metallschicht bei einer Abzugsgeschwindigkeit von 30 mm/min im rechten Winkel zur Plattenoberfläche bestimmt.

In Tabelle 2 sind die Ergebnisse der Haftfestigkeitsmessungen an den Formmassen 1 bis 11 nach den Vorbehandlungen B1 bis B7 aufgeführt.

Tabelle 2

| Beispiel | Formmasse-Nr. | Vorbehandlung | Haftfestigkeit N/25 mm |
|---|---|---|---|
| 1V | 1 | B1 | 5 |
| 2V | 1 | B2 | 5 |
| 3V | 1 | B3 | 6 |
| 4 | 1 | B4 | 8 |
| 5V | 2 | B1 | 6 |
| 6V | 2 | B3 | 6 |
| 7 | 2 | B4 | 36 |
| 8 | 2 | B5 | 30 |
| 9V | 3 | B1 | 5 |
| 10 | 3 | B4 | 39 |
| 11 | 3 | B6 | 24 |
| 12 | 3 | B7 | 48 |
| 13V | 4 | B1 | 10 |
| 14 | 4 | B4 | 18 |
| 15 | 5 | B7 | 38 |
| 16 | 6 | B7 | 55 |
| 17V | 7 | B1 | 8 |
| 18 | 7 | B4 | 53 |
| 19V | 8 | B1 | 6 |
| 20 | 8 | B4 | 48 |
| 21V | 9 | B1 | 10 |
| 22 | 9 | B4 | 42 |
| 23 | 10 | B4 | 47 |
| 24 | 11 | B7 | 50 |

Die Ergebnisse zeigen deutlich, daß durch die Behandlung mit sauren oder alkalischen Reagentien in überwiegend organischen Lösungsmitteln im Vergleich zur Behandlung in wäßrigen Lösungsmitteln bei der anschließenden Metallisierung bessere Haftfestigkeiten erreicht werden.

**Patentansprüche**

**1.** Verfahren zur Oberflächenbehandlung von Formkörpern auf der Basis von flüssigkristallinen Polymeren mit sauren oder alkalischen Reagentien, dadurch gekennzeichnet, daß die sauren oder alkalischen Reagentien in einem Lösungsmittel eingesetzt werden, das zu mindestens 60 Gew.-% aus einem organischen Lösungsmittel besteht.

**2.** Verfahren nach Anspruch 1, dadurch gekennzeichnet, daß als saures Reagenz HCl verwendet wird.

**3.** Verfahren nach Anspruch 1, dadurch gekennzeichnet, daß als alkalisches Reagenz KOH verwendet wird.

4. Verfahren nach den Ansprüchen 1 bis 3, dadurch gekennzeichnet, daß als Lösungsmittel $CH_3OH$ und/oder i-$C_3H_7OH$ verwendet werden.